# EUROPEAN PATENT APPLICATION

(11) **EP 1 976 029 A1**
(43) Date of publication of application: **01.10.2008**
(21) Application number: 06843047.9
(22) Date of filing: 22.12.2006
(51) Int. Cl.: H01L 33/00

(54) **SEMICONDUCTOR DISPLAY DEVICE AND PROCESS FOR MANUFACTURING THE SAME**

(30) Priority: 19.01.2006 JP 2006011564
(71) Applicant: Rohm Co., Ltd., Kyoto-shi, Kyoto 6158585 (JP)
(72) Inventor: ISHIHARA, Takayuki, Kyoto-shi, Kyoto 615-8585 (JP); KIGOSHI, Satohiro, Kyoto-shi, Kyoto 615-8585 (JP)
(74) Representative: TBK-Patent
(86) International application number: PCT/JP2006/325588
(87) International publication number: WO 2007/083481

(57) **Abstract**

To provide a semiconductor display device capable of being easily manufactured and a method for manufacturing the semiconductor display device.

The semiconductor display unit 1 includes: a printed circuit board 3 with a display section 2 formed thereon; a protection member 4; a embankment member 5; X lines 6; and Y lines 7. The embankment member 5 is composed of silicon resin which is capable of repelling epoxy resin constituting the protection member 4. Even when the embankment member 5 is lower than the protection member 4 or even when potting is performed to make the liquid epoxy resin 21 higher than the embankment member 5 at a manufacturing process, the epoxy resin 21 is repelled by the embankment member 5 and dose not spill.

## Description

### Technical Field

The present invention relates to a semiconductor display device forming an image through a plurality of semiconductor light emitting elements and a method for manufacturing the same.

### Background Art

A technique to cover a plurality of semiconductor elements (semiconductor light emitting elements), fine metallic wires, and the like which are arranged on a substrate with a protection member made of resin is known.

For example, Patent Literature 1 discloses a semiconductor device which includes a substrate provided with a plurality of through-holes and semiconductor elements arranged in the vicinities of the respective through-holes, a embankment member which is made of resin and formed on the substrate so as to surround a region where the plurality of semiconductor elements are arranged, and a protection member which is made of resin and formed at the inside of the embankment member.

In a manufacturing process of this semiconductor device, first, the semiconductor elements are arranged in the vicinities of the respective through-holes, and then the through-holes are connected to the respective semiconductor elements individually by two bonding wires. Next, the embankment member is formed by application to the substrate so as to surround the region where the semiconductor elements are arranged. Herein, at the formation of the embankment member, resin constituting the embankment member is applied twice to form the embankment member composed of two resin layers on the substrate. The embankment member can be thus made higher than a desired height of the protection member.

Next, the resin constituting the embankment member and liquid resin having a high wettability are dropped within the embankment member, and the dropped resin is cured at a predetermined temperature, thus forming the protection member only within the embankment member so as to cover the semiconductor elements.

In the semiconductor device, since the two resin layers are applied to form the high embankment member, there is an advantage that the liquid resin is less likely to spill out of the embankment member when the liquid resin is dropped to form the protection member.
Patent Literature 1: Japanese Patent Laid-open Publication No. 2002-270627

### Disclosure of the Invention

### Problems to be Solved by the Invention

However, since the through-holes are connected to the respective semiconductor elements individually by the two bonding wires, the manufacturing process is complicated, and the semiconductor device frequently breaks down because of disconnection of one of the bonding wires. Moreover, arranging the through-holes and semiconductor elements at different positions from each other increases the size.

Moreover, since the protection member is composed of the resin having high wettability for the resin constituting the embankment member, the resin constituting the protection member easily stick to the resin constituting the embankment member and therefore cannot repel the same. Accordingly, the embankment member must be higher than the desired height of the protection member, and the resin constituting the embankment member must be applied twice as described above. The manufacturing process of the semiconductor device is thus complicated.

The present invention was made to solve the aforementioned problems, and an object of the present invention is to provide a semiconductor display device which can be easily manufactured and a method for manufacturing the semiconductor display device.

### Means for Solving the Problem

To achieve the aforementioned object, an invention of claim 1 is a semiconductor display device, including: a substrate with a surface on a part of which a display section is formed, the display section including a plurality of through-holes with conductive members formed thereon and semiconductor light emitting elements provided on the respective through-holes; a protection member which is made of resin and covers a surface of the display section; and a embankment member which is made of resin and formed to surround an outer periphery of the display section for preventing the protection member from spilling out. The embankment member is made of resin repelling resin constituting the protection member.

An invention of claim 2 is the semiconductor display device according to claim 1 in which the protection member is higher than the embankment member.

An invention of claim 3 is the semiconductor display device according to any one of claims 1 to 2, in which the embankment member is spaced from the display section by a predetermined distance.

An invention of claim 4 is the semiconductor display device according to any one of claims 1 to 3, in which a sub-embankment member is formed to surround an outer periphery of the embankment member at a predetermined distance therefrom.

An invention of claim 5 is the semiconductor display device according to any one of claims 1 to 4, in which a metallic plate-shaped reinforcement member is provided in at least an area of a rear surface of the substrate corresponding to the display section.

An invention of claim 6 is the semiconductor display device according to any one of claims 1 to 5, in which a conductive closing member is formed to close an opening of each of the through-holes on a side where the semiconductor light emitting elements are provided.

An invention of claim 7 is a method for manufacturing a semiconductor display device, comprising: a first step of forming a display section on a substrate, the display section including a plurality of through-holes with conductive members formed thereon and semiconductor light emitting elements provided on the respective through-holes; a second step of forming a embankment member which is made of resin and surrounds an outer periphery of the display section; and a third step of potting to an inside of the embankment member with liquid resin which is repelled by resin constituting the embankment member and is higher than the embankment member so as to cover a surface of the display section, and then curing the liquid resin to form a protection member.

### Effect of the Invention

According to the present invention, by arranging the semiconductor light emitting elements on the respective though-holes with the conductive members thereon, the conductive members formed on the through-holes and the semiconductor light emitting elements are electrically connected at the same time as the arrangement, thus facilitating the manufacturing process. Moreover, by directly connecting the conductive member and the semiconductor light emitting elements, at least one of the fine metallic wires to connect the conductive members and semiconductor light emitting elements can be omitted, thus reducing breakdowns due to disconnection of the fine metallic wires. Furthermore, by arranging the semiconductor light emitting elements on the through-holes, the semiconductor display device can be made smaller than that in the case where the semiconductor light emitting elements are arranged at different positions from the through-holes.

Moreover, the embankment member is composed of resin repelling the resin constituting the protection member, and the resin constituting the protection member is repelled by the resin constituting the embankment member at the manufacturing process forming the protection member. If the embankment member is lower than the desired height of the protection member, it is therefore possible to prevent liquid resin dropped within the embankment member to form the protection member from spilling out of the embankment member over the embankment member. The embankment member can be therefore made lower than the protection member, so that the manufacturing process of the semiconductor display process can be facilitated. The semiconductor display device can be easily manufactured.

### Brief Description of the Drawings

FIG. 1 is a perspective view showing an entire semiconductor display device according to the present invention.
FIG. 2 is a schematic cross-sectional view taken along a line II-II of FIG. 1.
FIG. 3 is an enlarged plan view of a rectangle III of FIG. 1.
FIG. 4 is a cross-sectional view of FIG. 3 taken along a line IV-IV.
FIG. 5 is a schematic cross-sectional view of the semiconductor display device at a step of the manufacturing process of the semiconductor display device according to the present invention.
FIG. 6 is a schematic cross-sectional view of the semiconductor display device at another step of the manufacturing process of the semiconductor display device according to the present invention.
FIG. 7 is a schematic cross-sectional view of the semiconductor display device at still another step of the manufacturing process of the semiconductor display device according to the present invention.
FIG. 8 is a schematic cross-sectional view showing a modification of the semiconductor display device.
FIG. 9 is a schematic cross-sectional view showing another modification of the semiconductor display device.
FIG. 10 is a schematic cross-sectional view showing still another modification of the semiconductor display device.
FIG. 11 is a cross-sectional view of the modification of the semiconductor display device around a pixel.

### Explanation of Reference Numerals

- 1,: SEMICONDUCTOR DISPLAY DEVICE
- 2,: DISPLAY SECTION
- 3,: PRINTED CIRCUIT BOARD
- 3a,: PRINTED CIRCUIT BOARD
- 4,: PROTECTION MEMBER
- 5,: EMBANKMENT MEMBER
- 5a,: SUB-BANKING MEMBER
- 6,: X LINE
- 6a,: EXTERNAL TERMINAL
- 7,: Y LINE
- 7a,: EXTERNAL TERMINAL
- 11,: PIXEL
- 12,: THROUGH-HOLE
- 13,: SEMICONDUCTOR LIGHT EMITTING ELEMENT
- 14,: X METALLIC FILM
- 15,: Y METALLIC FILM
- 14,: FINE METALLIC WIRE
- 21,: EPOXY RESIN
- 31,: REINFORCEMENT MEMBER
- 35,: CLOSING MEMBER

### Best Mode for Carrying out the Invention

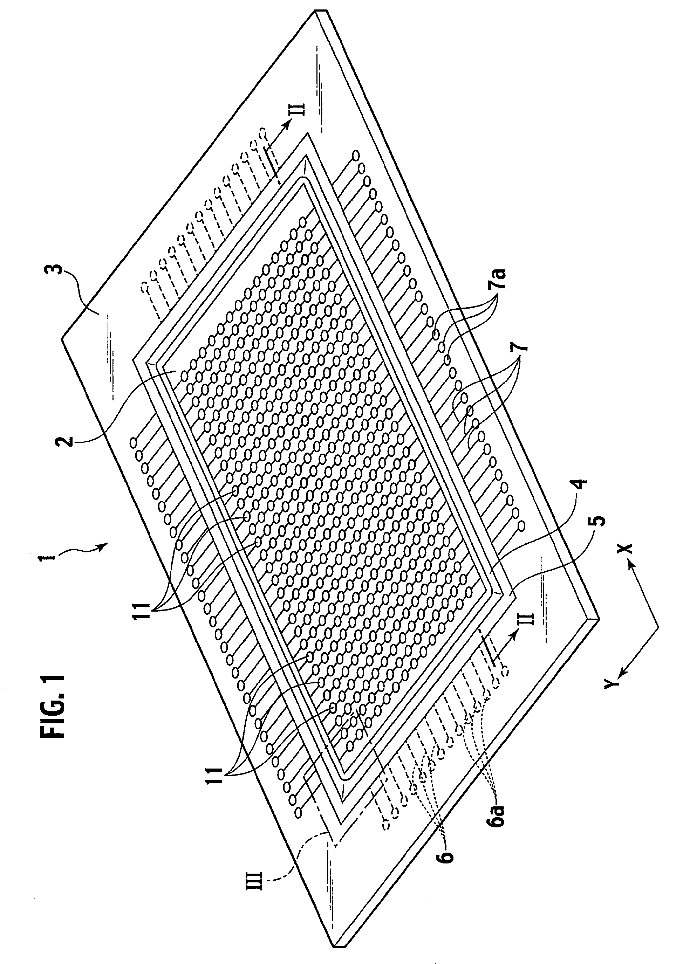

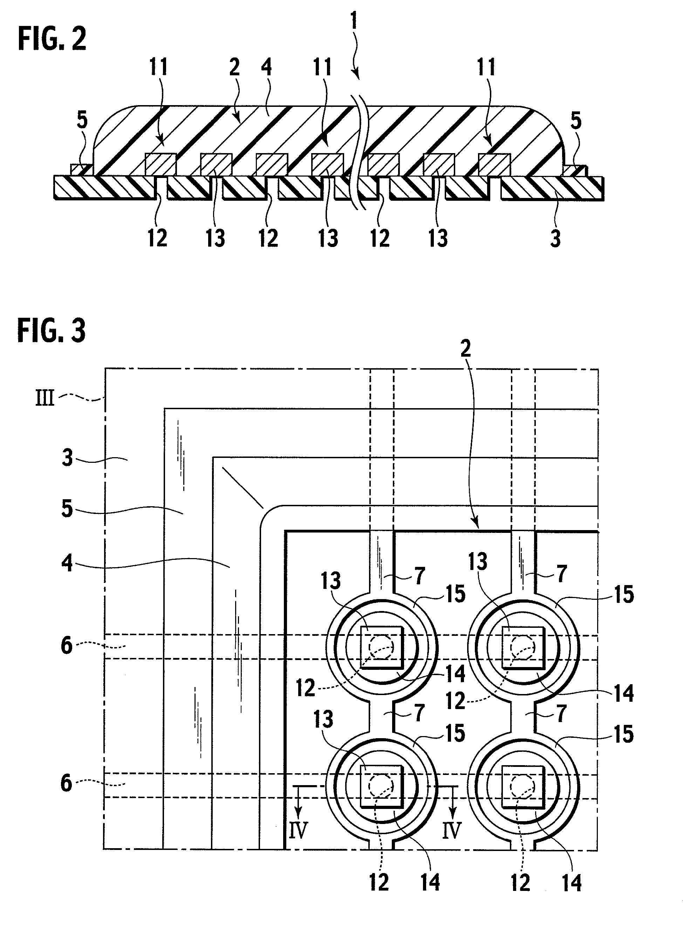

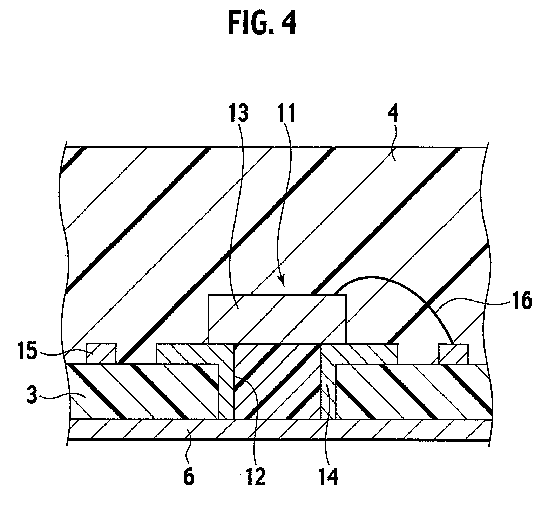

Hereinafter, a description is given of an embodiment of the present invention with reference to the drawings. FIG. 1 is a perspective view showing an entire semiconductor display device according to the present invention. FIG. 2 is a schematic cross-sectional view along a line II-II of FIG. 1. FIG. 3 is an enlarged plan view of a rectangle III of FIG. 1. FIG. 4 is a cross-sectional view of a line IV-IV of FIG. 1. In FIG. 2, X lines 6 and Y lines 7, fine metallic wires 16, and the like, which are described later, are omitted for convenience.

As shown in FIGS. 1 and 2, a semiconductor display device 1 includes a printed circuit board 3 with a display section 2 formed thereon, a protection member 4, an embankment member 5, the X lines 6, and the Y lines 7.

The printed circuit board 3 may be a glass epoxy substrate or the like. The display section 2 is provided in the center of the printed circuit board 3. In the display section 2, a plurality of pixels are provided in a matrix.

As shown in FIGS. 3 and 4, in each pixel 11, a through-hole 12 is formed and a semiconductor light emitting element 13 is formed on the through-hole 12.

The through-holes 12 are formed so as to penetrate the printed circuit board 3. On the inner periphery and the outer periphery of the upper end of each through-hole 12, an X metallic film 14 is formed. The X metallic film 14 is equivalent to a conductive member described in claims. The X metallic films 14 are electrically connected to the respective X lines 6 on the rear surface of the printed circuit board 3. At the inside of the X metallic film 14 formed on each through-hole 12, epoxy resin is embedded.

A round Y metallic film 15 is formed at a certain distance from each X metallic film 14 so as to surround outer peripheral part of an upper surface of the through-hole 12. The Y metallic films 15 are integrally formed with the Y lines 7 and electrically connected thereto.

Each of the semiconductor light emitting elements 13 is composed of a light emitting diode which includes a light emitting layer (not shown) at the center in a top-bottom direction. The bottom surface side of each semiconductor light emitting element 13 is electrically connected to the X metallic film 14. The top surface side of each semiconductor light emitting element 13 is bonded by a fine metallic wire 16 to be electrically connected to the Y metallic film 15.

When voltage is applied to any of the X lines 6 and the Y lines 7, electrons and holes can be injected to the semiconductor light emitting element 13 located at a position where the X lines 6 and the Y lines 7 to which the voltage is thus applied intersect with each other. Consequently, the light emitting layer of the semiconductor light emitting element 13 into which electrons and holes are injected is allowed to emit light and to display an image.

As shown in FIG. 2, the protection member 4 is composed of light transmitting epoxy resin (for example, tension: about 30 Dyne/cm) and is formed higher than the semiconductor light emitting elements 13 so as to cover the display section 2. Preferably, the epoxy resin constituting the protection member 4 has a resin viscosity of about 10 mPa·s to about 10 Pa·s and has a curing temperature of about 60°C to 150°C. The protection member 4 has a flat part positioned over the display section 2. The flat part of the protection member 4 has a thickness of about 1.0 mm. The thickness of the flat part of the protection member 4 is not particularly limited to about 1.0 mm but preferably about 0.3 mm to 5.0 mm.

The protection member 4 is for protecting the semiconductor light emitting elements 13. Moreover, the epoxy resin has a refraction index larger than that of air. Accordingly, by providing the epoxy resin between each semiconductor light emitting element 13 and air, light emitted by the semiconductor light emitting elements 13 can be prevented from being reflected at an interface between each light emitting element 13 and the outside. This allows light to be emitted from the light emitting elements 13 to the outside more efficiently.

As shown in FIGS. 1 and 2, the embankment member 5 is formed at a distance of not less than about 1.0 mm from the outer periphery of the display section 2 so as to surround the display section 2. By forming the embankment member 5 at a distance of not less than about 1.0 mm from the display section 2, the outer peripheral sloped part of the protection member 2 can be formed only outside of the display section 2, so that it is possible to make the area of the protection member 4 over the display section 2 flat. The embankment member 5 has a width of not less than about 0.3 mm. Preferably, the width of the embankment member 5 is about 0.5 mm to 2.0 mm.

The embankment member 5 is composed of silicon resin capable of repelling the epoxy resin (for example, tension: about 20 Dyne/cm) constituting the protection member 4. Accordingly, the protection member 4 is not formed on the upper surface of the embankment member 5. It is therefore possible to prevent the protection member 4 formed within the embankment member 5 from spilling over the embankment member 5 even if the embankment member 5 is formed lower than the protection member 4. The embankment member 5 can be formed higher than the protection member 4.

Each of the X lines 6 is composed of a metallic film and formed on the rear surface of the printed circuit board 3 so as to extend in the X direction. At an end of each X line 6, an external terminal 6a is formed for connection with an external controller (not shown).

Each of the Y lines 7 is composed of a metallic film and formed on the front surface of the printed circuit board 3 so as to extend in the Y direction. The Y lines 7 are thus insulated from the X lines 6 by the printed circuit board 3. At an end of each Y line 7, an external terminal 7a is formed for connection with an external controller (not shown).

At intersections of the X lines 6 and the Y lines 7, the aforementioned pixels 11 are individually provided. By applying voltage to the semiconductor light emitting elements 13 of desired ones of the pixels 11 by the controller through the external terminals 6a and 7a, the semiconductor light emitting elements 13 are allowed to emit light to form an image.

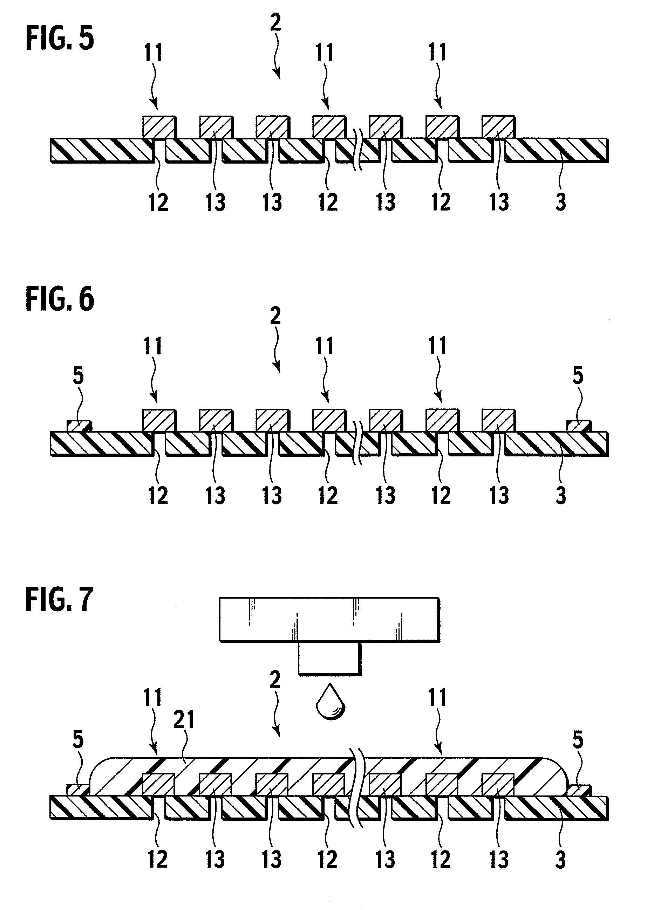

Next, a description is given of a manufacturing process of the aforementioned semiconductor display device with reference to the drawings. FIGS. 5 to 7 are schematic cross-sectional views of the semiconductor display device at individual steps of the manufacturing process of the semiconductor display device according to the present invention.

First, as shown in FIG. 5, after the through-holes 12 are formed in the printed circuit board 3, the lines 6 and 7 (not shown) including the external terminals 6a and 7a and metallic films 14 and 15 are printed. Next, the semiconductor light emitting elements 13 are arranged on the respective through-holes 12 to be connected to the X lines 6 through the X metallic films 14. Subsequently, the semiconductor light emitting elements 13 and the Y lines 7 are bonded by the fine metallic wires 16, thus forming the display section 2 on the printed circuit board 3 (first step).

Next, as shown in FIG. 6, the embankment member 5 composed of silicon resin is formed by silk printing so as to surround the outer periphery of the display section 2 at a certain distance from the same (second step).

Next, as shown in FIG. 7, potting is performed for the inside of the embankment member 5 with liquid epoxy resin 21 so that the epoxy resin 21 becomes higher than the embankment member and covers the display section 2 (third step). Herein, the embankment member 5 is made of silicon resin capable of repelling the epoxy resin 21. Accordingly, since the epoxy resin 21 is repelled by the upper surface of the embankment member 5, the epoxy resin 21 does not spill out over the embankment member 5 even if the epoxy resin 21 becomes higher than the embankment member 5.

When the epoxy resin 21 reaches a desired height (for example, about 1.0 mm), the potting is stopped. The epoxy resin 21 is heated to a curing temperature thereof (for example, about 60°C to 150°C) and is cured. The protection member 4 composed of the cured epoxy resin 21 as shown in FIG. 2 is formed (third Step), thus completing the semiconductor display device 1.

As described above, the semiconductor light emitting elements 13 are arranged on the respective through-holes 12 with the X metallic films 14 formed thereon. Accordingly, the semiconductor light emitting elements 13 and X metallic films 14 can be connected to each other at the same time as arranging the same, thus facilitating the manufacturing process. Moreover, the X metallic films 14 and semiconductor light emitting elements 13 are electrically connected directly. Accordingly, it is possible to omit fine metallic wires connecting the X metallic films 14 and semiconductor light emitting elements 13, thus reducing breakdowns due to disconnection of the fine metallic wires.

Moreover, the semiconductor light emitting elements 13 are arranged on the respective through-holes 12, so that the semiconductor display device 1 can be made smaller than that in the case where the semiconductor light emitting elements are arranged on positions different from the through-holes.

Moreover, the protection member 4 is composed of epoxy resin, and the embankment member 5 is composed of silicon resin, which is capable of repelling epoxy resin. Accordingly, even if potting is performed so that the liquid epoxy resin 21 becomes higher than the embankment member 5 at the manufacturing step of forming the protection member 4, the liquid epoxy resin 21 is repelled by the embankment member 5. Even the embankment member 5, which is lower than the desired height of the protection member 5, can prevent the epoxy resin 21 (protection member 4) from spilling out. It is therefore possible to easily form the protection member 4 so as to be higher than the embankment member 5 and facilitate the manufacturing process of the embankment member 5, thus easily manufacturing the semiconductor display device 1.

Moreover, the embankment member 5 is formed at a certain distance from the outer periphery of the display section 2. Accordingly, the part of the protection member 4 positioned over the display section 2 can be made flat. It is therefore possible to reduce image distortion in the outer periphery of the display section 2, thus providing high quality images.

Hereinabove, the present invention is described in detail using the embodiment, but it is apparent to those skilled in the art that the present invention is not limited to the embodiment described in the specification. The present invention can be carried out as modified and changed modes without departing from the spirit and scope of the invention defined by the description of claims. Accordingly, the description of this specification is for illustrative purposes and does not impose any limitation on the present invention. A description is given below of modified modes obtained by partially changing the embodiment.

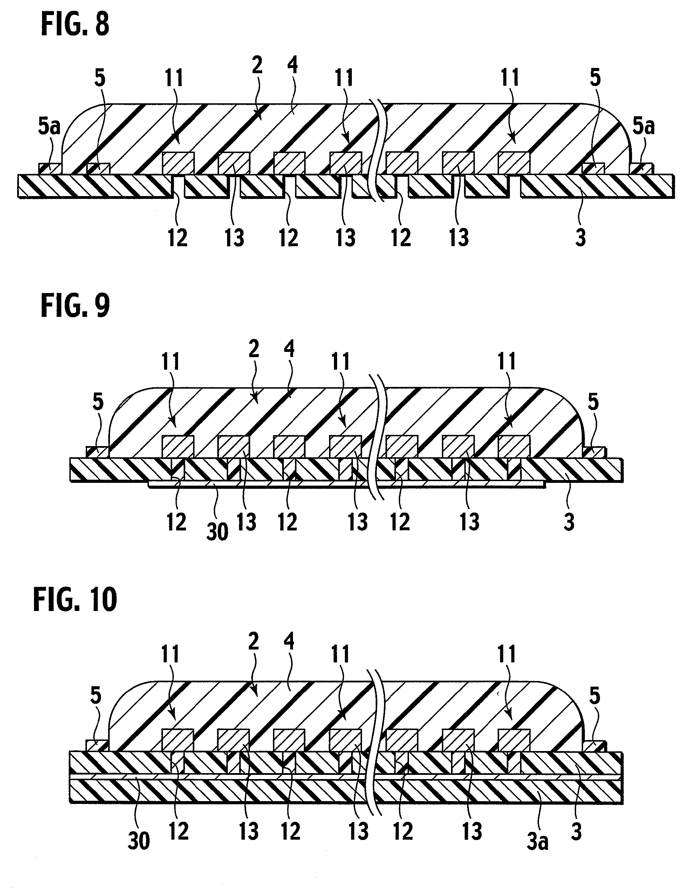

For example, as shown in FIG. 8, a sub-embankment member 5a may be formed at a certain distance from the embankment member 5 at the outside of the same. The sub-embankment member 5a is composed of silicon resin which is the same as the embankment member 5 and is capable of repelling epoxy resin constituting the protection member 4. By providing the sub-embankment member 5 as described above, even if liquid epoxy resin to form the protection member 4 spills out of the embankment member 5, the epoxy resin can be held back by the sub-embankment member 5. It is therefore possible to further prevent liquid epoxy resin from spilling out. The embankment member 5 is preferably space from the sub-embankment member 5a by a distance of about 0.5 mm but also may be spaced by another distance within a range of about 0.1 to 5.0 mm, for example.

In addition, as shown in FIG. 9, the semiconductor display device may include a plate-shaped reinforcement member 31 made of metal such as aluminum in a region of the rear surface of the printed circuit board 3 corresponding to the display section 2. By providing the reinforcement member 31 on the rear surface of the printed circuit board 3, it is possible to prevent warpage of the printed circuit board 3 due to the difference in thermal expansion coefficient between the protection member 4 and printed circuit board 3 at curing of the epoxy resin constituting the protection member 4.

Moreover, by making the reinforcement member 31 of a material having a radiation performance such as aluminum, the radiation performance of the display section 2 can be increased. Desirably, grease or the like, which has insulating properties and high thermal conductivity, is applied between the printed circuit board 3 and reinforcement member 31.

As shown in FIG. 10, the semiconductor display device may further include a printed circuit board 3a on the rear surface of the reinforcement member 31, and the aforementioned X wires 6 may be formed in the printed circuit board 3a.

The materials constituting the protection member 4 and embankment member 5 are just examples and are not limited to the aforementioned materials. The embankment member 5 only needs to be composed of a material capable of repelling the material constituting the protection member and is not particularly limited.

The method of forming the embankment member 5 is not limited to silk printing and may be another printing, such as transfer and a dispenser.

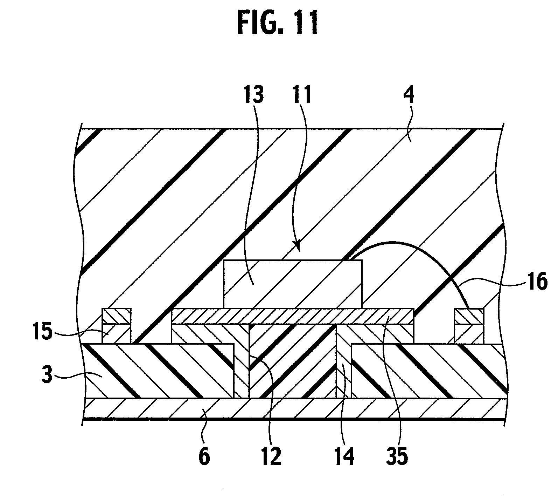

As shown in FIG. 11, an opening of each through-holes 12 on the semiconductor light emitting element 13 side may be closed by a closing member 35. The closing member 35 is made of a same metallic material as that of the metallic films 14 and 15 (for example, copper). The upper surface of each closing member 35 is Ni/At plated. By closing the opening of each through-hole 12 by the closing member 35 in such a manner, the entire surface of the opening of each through-hole 12 is electrically connected to the closing member 35, and the resistance value between the semiconductor light emitting element 13 and X metallic film 14 can be reduced. This allows sufficient current to flow even when the semiconductor light emitting elements 13 are misaligned to cause the bottom surface of each semiconductor light emitting element 13 to be shifted from the closing member 35 and exposed. It is therefore possible to reduce the diameters of the upper surfaces of the closing members 35 and X-side metallic films 14 and reduce the distances between the adjacent semiconductor light emitting elements 13, thus increasing the planar density of the pixels 11.

## Claims

1. A semiconductor display device, comprising:
a substrate with a surface on a part of which a display section is formed, the display section including a plurality of through-holes with conductive members formed thereon and semiconductor light emitting elements provided on the respective through-holes;
a protection member which is made of resin and covers a surface of the display section; and
a embankment member which is made of resin and formed to surround an outer periphery of the display section for preventing the protection member from spilling out, wherein
the embankment member is made of resin repelling resin constituting the protection member.

2. The semiconductor display device according to claim 1, wherein
the protection member is higher than the embankment member.

3. The semiconductor display device according to any one of claims 1 to 2, wherein
the embankment member is spaced from the display section by a predetermined distance.

4. The semiconductor display device according to any one of claims 1 to 3, wherein
a sub-embankment member is formed to surround an outer periphery of the embankment member at a predetermined distance therefrom.

5. The semiconductor display device according to any one of claims 1 to 4, wherein a metallic plate-shaped reinforcement member is provided in at least an area of a rear surface of the substrate corresponding to the display section.

6. The semiconductor display device according to any one of claims 1 to 5, wherein
a conductive closing member is formed to close an opening of each of the through-holes on a side where the semiconductor light emitting elements are provided.

7. A method for manufacturing a semiconductor display device, comprising:
a first step of forming a display section on a substrate, the display section including a plurality of through-holes with conductive members formed thereon and semiconductor light emitting elements provided on the respective through-holes;
a second step of forming a embankment member which is made of resin and surrounds an outer periphery of the display section; and
a third step of potting to an inside of the embankment member with liquid resin which is repelled by resin constituting the embankment member and is higher than the embankment member so as to cover a surface of the display section, and then curing the liquid resin to form a protection member.
